(19) Europäisches Patentamt
European Patent Office
Office européen des brevets

(11) **EP 3 242 398 B1**

(12) **FASCICULE DE BREVET EUROPEEN**

(45) Date de publication et mention de la délivrance du brevet:
**13.01.2021 Bulletin 2021/02**

(51) Int Cl.:
*H03K 3/84* (2006.01)     *H03K 5/14* (2014.01)
*H03K 19/003* (2006.01)     *H03K 19/20* (2006.01)

(21) Numéro de dépôt: **16198959.5**

(22) Date de dépôt: **15.11.2016**

(54) **GÉNÉRATEUR DE NOMBRES D'OSCILLATIONS**

GENERATOR VON SCHWINGUNGSZAHLEN

GENERATOR OF NUMBERS OF OSCILLATIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.05.2016 FR 1654082**

(43) Date de publication de la demande:
**08.11.2017 Bulletin 2017/45**

(73) Titulaire: **STMICROELECTRONICS (ROUSSET) SAS**
**13790 Rousset (FR)**

(72) Inventeurs:
• **MARTINEZ, Albert**
**13320 Bouc Bel Air (FR)**
• **AGOYAN, Michel**
**13012 Marseille (FR)**
• **NICOLAI, Jean**
**13790 Chateauneuf-le-Rouge (FR)**

(74) Mandataire: **Cabinet Beaumont**
**4, Place Robert Schuman**
**B.P. 1529**
**38025 Grenoble Cedex 1 (FR)**

(56) Documents cités:
**FR-A1- 3 023 396      US-A1- 2011 163 818**
**US-A1- 2012 221 616**

EP 3 242 398 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

<u>Domaine</u>

La présente description concerne de façon générale les circuits électroniques et, plus particulièrement, des circuits ou fonctions électroniques utilisables comme dans un circuit ou dispositif électronique. Un exemple d'application des circuits et fonctions électroniques de la présente description est la réalisation d'un générateur de nombres aléatoires. Un autre exemple d'application est la réalisation d'une fonction physique non clonable (PUF), par exemple pour générer des identifiants uniques ou des clés cryptographiques uniques. La présente description concerne plus particulièrement les générateurs de nombres aléatoires dans des applications de sécurité telles que de chiffrement, d'authentification, etc.

<u>Exposé de l'art antérieur</u>

Dans de nombreuses applications, des unités de traitement, par exemple des unités centrales de traitement (CPU) des microcontrôleurs, utilisent des nombres générés aléatoirement.
Les circuits de génération de nombres aléatoires utilisent divers circuits ou sous-ensembles qui peuvent avoir d'autres applications hors de la génération de nombres aléatoires. En particulier, un générateur de nombres aléatoires utilise des circuits de type oscillateur, multiplexeur, etc. qui, bien que tout particulièrement intéressants dans la génération de nombres aléatoires, ne sont pas limités à ces applications.
Les générateurs de nombres auxquels s'applique la présente description sont basés sur l'utilisation de lignes à retard rebouclées l'une sur l'autre.
Il existe un besoin d'amélioration des générateurs de nombres aléatoires ou des circuits fournissant des fonctions physiques non clonables.
Plus généralement, il existe un besoin d'amélioration de fonctions électroniques logiques, utilisables non seulement dans des applications de génération de nombres aléatoires ou reproductibles, mais également dans d'autres applications où des problèmes similaires se posent.
Le document US 2011/0163818 décrit un dispositif et procédé pour générer une séquence de bits aléatoires à base d'un oscillateur en anneaux.
Le document FR-A-3 023 396 décrit un générateur de nombres aléatoires.
Le document US 2012/0221616 décrit un circuit de génération d'un nombre aléatoire comprenant un circuit oscillant et un circuit de rétention.

<u>Résumé</u>

L'invention est définie par la revendication indépendante 1.
Un mode de réalisation pallie tout ou partie des inconvénients des solutions usuelles de génération de nombres aléatoires ou de fonctions physiques pour identifiants uniques, clés cryptographiques, etc.
Un mode de réalisation selon un aspect de la présente description propose un circuit dont le comportement est modélisable pour réaliser un générateur de nombres d'oscillations à des fins de génération de nombres aléatoires ou d'un nombre non clonable.
Un mode de réalisation selon cet aspect propose un générateur dont le comportement puisse être vérifié.
Un mode de réalisation selon cet aspect propose une solution compatible avec l'utilisation de cellules standard d'une technologie électronique donnée.
Un mode de réalisation selon un autre aspect de la présente description propose une structure de multiplexeur symétrique, c'est-à-dire ayant un comportement temporel similaire pour faire transiter un front montant et pour faire transiter un front descendant.
Un mode de réalisation selon cet autre aspect propose une structure de multiplexeur compatible avec les structures usuelles de multiplexeur.
Un mode de réalisation selon encore un autre aspect de la présente description propose un compteur de changement d'état (d'oscillations) de signaux bruités.
Un mode de réalisation selon cet encore autre aspect propose une solution plus particulièrement adaptée au comptage d'une sortie d'un générateur d'oscillations.
Ainsi, un premier aspect prévoit un circuit de génération d'un nombre d'oscillations comportant :

une première branche comprenant au moins une ligne à retard apportant des retards symétriques sur fronts montants et sur fronts descendants et au moins un élément retardateur asymétrique apportant des retards différents sur fronts montants et sur fronts descendants ;
une deuxième branche, rebouclée sur la première et comprenant au moins une ligne à retard apportant des retards symétriques sur fronts montants et sur fronts descendants.

Selon un mode de réalisation de ce premier aspect, la deuxième branche comporte en outre au moins un élément retardateur asymétrique apportant des retards différents sur fronts montants et sur fronts descendants.

Selon ce premier aspect, des portes de type NON-ET, combinant les sorties respectives des branches avec un signal de commande, sont intercalées entre les sorties respectives de chaque branche et l'entrée de l'autre branche.

Selon un mode de réalisation de ce premier aspect, les lignes à retard sont constituées d'éléments logiques ramenant à une fonction non inverseuse à une seule entrée et dont les temps de montée et de descente sont identiques.

Selon un mode de réalisation de ce premier aspect, le ou les éléments retardateurs sont constitués de circuits logiques non inverseurs.

Selon ce premier aspect, chaque élément retardateur est constitué d'une fonction logique que l'on peut ramener à une fonction non inverseuse ne dépendant que d'une seule entrée et dont les temps de montée et de descente sont différents.

Selon un mode de réalisation de ce premier aspect, la ou les branches comportent en outre une deuxième ligne à retard apportant des retards symétriques sur fronts montants et sur fronts descendants, connectée en parallèle sur l'élément retardateur de la branche concernée.

Un mode de réalisation prévoit également un générateur de nombres comportant :

au moins un circuit de génération d'un nombre d'oscillations ; et
au moins un compteur du nombre d'oscillations générées par ledit circuit.

Selon un mode de réalisation, ledit circuit est configuré pour générer un nombre aléatoire d'oscillations.

Un mode de réalisation prévoit également un dispositif électronique comportant au moins un générateur de nombres configuré pour générer un nombre reproductible.

Un mode de réalisation d'un deuxième aspect prévoit un multiplexeur logique, deux vers un, comportant :

deux bornes d'entrée ;
une borne de sortie ;
une borne de commande ; et
un multiple de quatre multiplexeurs unitaires deux vers un raccordés en série, un premier multiplexeur unitaire ayant ses entrées connectées aux bornes d'entrée, un dernier multiplexeur unitaire ayant sa sortie connectée à la borne de sortie et les autres multiplexeurs unitaires ayant leurs entrées respectives interconnectées à la sortie du multiplexeur précédent dans l'association en série, une moitié des multiplexeurs unitaires étant commandée en inverse par rapport à une autre moitié.

Selon un mode de réalisation de ce deuxième aspect, les multiplexeurs unitaires sont des multiplexeurs inverseurs.

Selon un mode de réalisation de ce deuxième aspect, tous les multiplexeurs unitaires sont identiques.

Selon un mode de réalisation de ce deuxième aspect, une moitié des multiplexeurs a ses entrées de commande connectées à ladite borne de commande.

Selon un mode de réalisation de ce deuxième aspect, l'autre moitié des multiplexeurs a ses entrées de commande connectées en sortie d'un multiplexeur dont une entrée est connectée à ladite borne de commande.

Un mode de réalisation prévoit également un multiplexeur quatre vers un, comportant trois multiplexeurs logiques deux vers un.

Un mode de réalisation prévoit également un circuit de génération de nombres, comportant au moins un multiplexeur tel que ci-dessus.

Un mode de réalisation d'un troisième aspect prévoit un circuit de comptage d'impulsions fournies par un circuit ayant au moins deux bornes de fourniture de signaux impulsionnels inversés, comportant :

un premier compteur des impulsions d'un premier signal impulsionnel fournissant un premier compte ;
un deuxième compteur des impulsions d'un deuxième signal impulsionnel fournissant un deuxième compte ; et
un élément de sélection de l'un des comptes.

Selon un mode de réalisation de ce troisième aspect, l'élément de sélection reçoit, outre les comptes fournis par les compteurs, lesdits signaux impulsionnels.

Selon un mode de réalisation de ce troisième aspect, l'élément de sélection prend en compte la disparition d'impulsions d'un des signaux impulsionnels.

Selon un mode de réalisation de ce troisième aspect, le compte sélectionné est celui du compteur dont le signal impulsionnel s'arrête en premier.

Selon un mode de réalisation de ce troisième aspect, le compte sélectionné est celui du compteur dont le signal impulsionnel s'arrête en dernier.

Selon un mode de réalisation de ce troisième aspect, le compte sélectionné est celui :

du compteur ayant le plus grand compte si les deux comptes ont la même parité ; ou
du compteur ayant le plus grand compte si ce compte est pair et le plus petit si le compte est impair.

Selon un mode de réalisation de ce troisième aspect, le circuit de sélection fournit le bit de poids faible du compte sélectionné.

Selon un mode de réalisation de ce troisième aspect, les impulsions sont fournies par deux lignes à retard rebouclées l'une sur l'autre d'un générateur d'oscillations.

Selon un mode de réalisation de ce troisième aspect, le circuit de comptage d'impulsions comporte en outre, en amont de chaque compteur, un circuit de mise en forme des impulsions.

Selon un mode de réalisation de ce troisième aspect, le circuit de mise en forme comporte une bascule dont une sortie est rebouclée sur une entrée d'initialisation ou de réinitialisation (RN) après traversée d'un élément retardateur.

Selon un mode de réalisation de ce troisième aspect, le retard apporté par l'élément retardateur est supérieur à la durée minimale de prise en compte d'une impulsion par la bascule.

Un mode de réalisation prévoit un circuit de génération de nombres, comportant au moins un circuit de comptage d'impulsions.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de façon schématique et sous forme de blocs, un mode de réalisation d'un circuit électronique du type auquel s'appliquent les modes de réalisation décrits ;
la figure 2 représente un exemple de circuit de génération d'un nombre d'oscillations pour un générateur de nombres aléatoires ou d'un nombre non clonable ;
les figures 3A, 3B, 3C, 3D et 3E illustrent, sous forme de chronogrammes, une nouvelle interprétation du fonctionnement d'un générateur d'un nombre d'oscillations ;
la figure 4 représente un mode de réalisation d'un générateur d'oscillations ;
la figure 5 représente, de façon schématique et sous forme de blocs, une variante de réalisation d'un générateur d'un nombre d'oscillations ;
la figure 6 représente, de façon schématique, un mode de réalisation de lignes à retard pour générateur de nombre d'oscillations ;
la figure 7 représente, de façon schématique, un mode de réalisation d'un circuit multiplexeur symétrique deux vers un ;
la figure 8 représente un mode de réalisation d'un multiplexeur symétrique quatre vers un ;
la figure 9 représente un mode de réalisation d'un générateur de nombres aléatoires basé sur un générateur de nombre d'oscillations ;
la figure 10 représente un mode de réalisation d'un circuit de mise en forme d'un signal impulsionnel ; et
les figures 11A, 11B, 11C et 11D illustrent, sous forme de chronogrammes, le fonctionnement du circuit de mise en forme de la figure 10.

### Description détaillée

De mêmes éléments ont été désignés par de mêmes références aux différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les éléments utiles à la compréhension des modes de réalisation décrits ont été représentés et seront détaillés. En particulier, les utilisations des nombres générés (aléatoires ou non clonables) et les applications des circuits intégrant le générateur décrit n'ont pas été détaillées, les modes de réalisation décrits étant compatibles avec les utilisations et applications usuelles. De façon arbitraire, on désigne par état 1, l'état haut d'un signal logique et par état 0 son état bas. Lorsque l'on fait référence aux termes "environ", "approximativement" ou "de l'ordre de", cela signifie à 10 % près, de préférence à 5 % près.

Le générateur de nombres objet de la présente description est décrit par la suite en relation avec un exemple de générateur de nombres aléatoires d'oscillations. Sauf précision contraire, tout ce qui est décrit par la suite s'applique cependant à un générateur de nombre d'oscillations pour fonction physique non clonable.

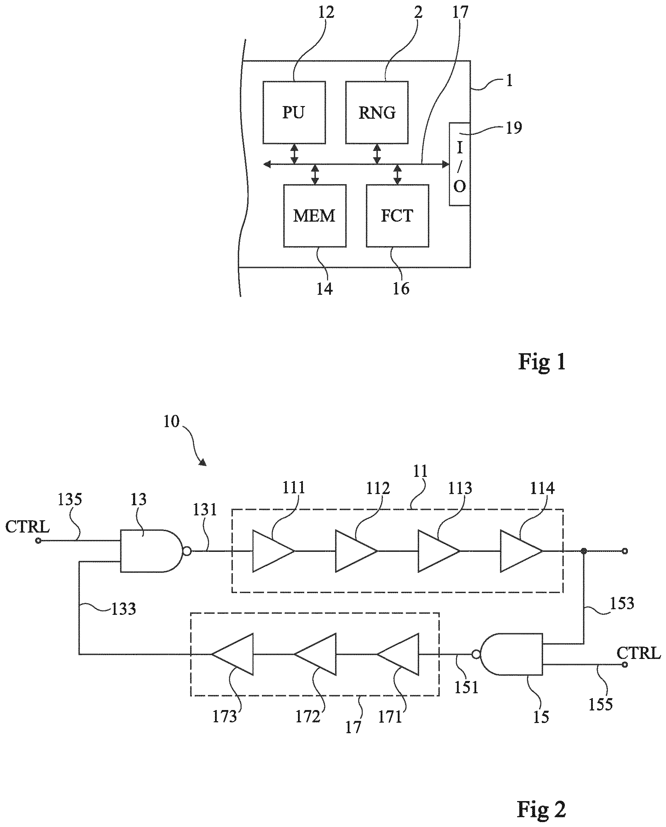

La figure 1 représente, de façon très schématique un circuit électronique 1 du type auquel s'appliquent les modes de réalisation qui vont être décrits.

Le circuit 1 comporte, entre autres :

une entité de calcul 12 ou de traitement (PU), par exemple une machine d'états, un microprocesseur, un circuit logique programmable, etc. ;
une ou plusieurs zones 14 (MEM) de stockage volatile et/ou non volatile pour stocker tout ou partie des données et clés ;
un ou plusieurs circuits 16 mettant en oeuvre diverses fonctions (FCT) liées à l'application à laquelle est destiné le circuit 1, par exemple un crypto processeur, un circuit de commande d'un capteur biométrique, etc. ;
un ou plusieurs bus 17 de données, d'adresses et/ou de commandes entre les différents éléments internes au circuit 1 et une interface d'entrée-sortie 19 (I/O) de communication avec l'extérieur du circuit 1 ; et
un ou plusieurs circuits 2 (RNG) de génération de nombres aléatoires.

La figure 2 représente un exemple de schéma électrique d'un générateur 10 usuel d'un nombre d'oscillations pour générateur de nombres aléatoires.

Ce générateur 10 est basé sur deux lignes à retard composées chacune d'éléments retardateurs en série, rebouclées l'une sur l'autre, chaque élément retardateur restituant le signal dans le même état (1 ou 0) que son entrée. Le nombre d'éléments retardateurs de chaque chaîne peut être différent ou identique. Dans l'exemple représenté, une première ligne 11 comporte quatre éléments retardateurs 111, 112, 113 et 114 en série entre une borne de sortie 131 d'une première porte logique 13 de type NON-ET (NAND) et une première borne d'entrée 153 d'une deuxième porte logique 15 de type NON-ET. Une deuxième ligne 17 comporte trois éléments retardateurs 171, 172 et 173 en série entre une borne de sortie 151 de la deuxième porte 15 et une première entrée 133 de la première porte 13. Les deuxièmes entrées respectives 135 et 155 des portes logiques 13 et 15 constituent des bornes d'entrée destinées à recevoir un même signal CTRL de commande (de déclenchement de la génération d'un nombre). Le nombre d'oscillations, qui conditionne le nombre aléatoire, est prélevé, par exemple, en sortie de la première ligne, c'est-à-dire sur la première entrée 153 de la porte 15. En variante, le nombre d'oscillations est prélevé en entrée 133 de la porte 13, en sortie 131 de la porte 13 ou en sortie 151 de la porte 15.

La différence entre les retards apportés par les deux lignes conditionne le rapport cyclique des signaux présents aux bornes 133 et 153.

En théorie, le générateur de la figure 2 oscille indéfiniment avec un rapport cyclique tant que le signal CTRL est à l'état 1. En pratique, en l'absence de bruit mais avec des éléments retardateurs (portes logiques) ayant des temps différents qui finissent par déformer suffisamment le rapport cyclique pour que l'oscillateur s'arrête, le générateur finit par s'arrêter après un nombre d'oscillations fixe. En présence de bruit (gigue de phase - jitter), le générateur finit par s'arrêter mais après un nombre d'oscillations dont la valeur varie.

Ainsi, le fait que le générateur s'arrête n'est pas en soi gênant, bien au contraire, mais ce qui est gênant est de ne pas pouvoir déterminer autour de quelle valeur (quel nombre d'oscillations) il s'arrêtera. En effet, pour que le générateur de nombres aléatoires fonctionne correctement, il faut qu'il ait accumulé suffisamment de bruit, donc un nombre d'oscillations suffisant afin que le résultat du comptage du nombre d'oscillations fournisse, quand le compteur s'arrête, un aléa suffisant au niveau de son bit de poids faible ou de quelques (moins de dix) bits de poids faible du compteur d'oscillations.

Les modes de réalisation décrits ci-dessous tirent leur origine dans une nouvelle analyse du comportement d'un générateur de nombres d'oscillations.

En particulier, les inventeurs ont constaté qu'il était possible de lier le comportement du générateur de nombres d'oscillations aux paramètres intrinsèques mais quantifiables des éléments qui le constituent.

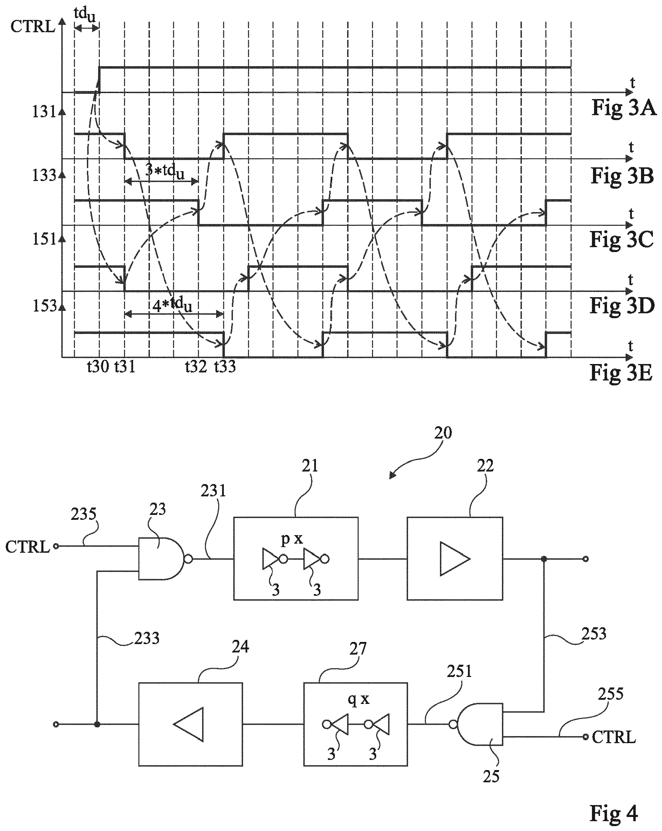

Les figures 3A, 3B, 3C, 3D et 3E illustrent, par des chronogrammes, le fonctionnement théorique du circuit de la figure 2. La figure 3A représente un exemple d'allure du signal CTRL. La figure 3B illustre un exemple correspondant d'allure du signal présent sur la sortie 131 de la porte 13. La figure 3C illustre un exemple correspondant d'allure du signal présent sur la sortie de la première ligne (l'entrée 133 de la porte 13). La figure 3D illustre un exemple correspondant d'allure du signal présent sur la sortie 151 de la porte 15. La figure 3E illustre un exemple correspondant d'allure du signal présent sur la sortie de la première ligne (l'entrée 153 de la porte 15).

On suppose que le retard apporté par chaque porte et par chaque élément retardateur vaut une valeur $td_u$, identique pour tous les éléments et portes.

Quand le signal CTRL est à l'état 0, les sorties 131 et 151 sont tout le temps à l'état 1. Par conséquent les sorties 133 et 153 des lignes 17 et 11 sont stables à l'état 1.

A un instant t30, le signal CTRL est basculé à l'état 1 pour activer la génération. Après un retard $td_u$, les sorties

131 et 151 basculent à l'état 0 à un instant t31. Les lignes 13 et 15 apportent respectivement des retards de 4*td$_u$ et de 3*td$_u$ aux fronts montants et descendants des signaux présents aux bornes 131 et 151. Par conséquent, le signal 133 bascule à l'état 1 à un instant t32, postérieur de 3*td$_u$ par rapport à l'instant t31 et le signal 153 bascule à l'état 1 à un instant t33, postérieur de 4*td$_u$ par rapport à l'instant t31.

Les signaux 131 et 151 basculent alors à l'état 1 avec un retard td$_u$ par rapport aux instants t32 et t33 respectivement, et ainsi de suite.

Le nombre d'oscillations prélevé, de préférence en sortie 153 (ou 133), lorsque l'oscillation s'arrête, est aléatoire. On notera que ce nombre d'oscillations peut être compté à n'importe quel point de la boucle.

Les inventeurs considèrent, qu'outre le bruit de phase, l'un des facteurs qui conduit à l'arrêt du générateur provient notamment d'un déséquilibre entre les temps de montée et les temps de descente des signaux, c'est-à-dire entre le temps que met un élément retardateur ou une porte pour commuter de l'état 1 vers l'état 0 et de l'état 0 vers l'état 1. En effet, le décalage entre les temps de montée et temps de descente d'une branche du générateur (ligne à retard plus porte NON-ET) entraîne qu'il arrive un moment où la durée d'un état devient inférieure au retard apporté par un élément de la ligne à retard.

Un problème est que ce "moment" est fonction du nombre d'éléments retardateurs de la ligne (accumulation des décalages temporels). On souhaiterait cependant pouvoir rendre contrôlable la durée au bout de laquelle un générateur s'arrête, afin, lors de la conception d'un nouveau circuit, de pouvoir garantir que le nombre d'oscillations avant l'arrêt du générateur est suffisant.

En reprenant les notations de l'exemple de la figure 2, on notera par la suite :

t1$_n$, l'instant d'un front (montant ou descendant) de rang n du signal de la sortie 131 ;
t2$_n$, l'instant d'un front (montant ou descendant) de rang n du signal de la sortie 151 ;
L1$_n$, la durée du niveau bas de rang n du signal de la sortie 131 (cette durée est liée au retard apporté par la deuxième ligne 17 plus la première porte 13) ;
H2$_n$, la durée du niveau haut de rang n du signal de la sortie 151 (cette durée est liée au retard apporté par la première ligne 11 plus la deuxième porte 15) ;
tr$_1$ et tf$_1$, les temps de montée et de descente respectifs du signal de la sortie 151 par rapport à l'instant de commutation de la borne 131 ; et
tr$_2$ et tf$_2$, les temps de montée et de descente respectifs du signal de la sortie 131 par rapport à l'instant de commutation de la borne 151.

Le comportement du générateur peut s'écrire à partir de suites arithmétiques.

En particulier, on peut écrire :

$$L1_n = t1_{2n+1} - t1_{2n} \; ;$$

et

$$H2_n = t2_{2n+2} - t2_{2n+1}.$$

Par ailleurs :

$$t1_{2n} = t2_{2n-1} + tf_2 \; ;$$

$$t1_{2n+1} = t2_{2n} + tr_2 \; ;$$

$$t2_{2n-1} = t1_{2n-2} + tr_1 \; ;$$

et

$$t2_{2n} = t1_{2n-1} + tf_1 \; ;$$

On peut en déduire :

$$L1_n = H2_{n-1} - \Delta fr_2, \text{ avec } \Delta fr_2 = tf_2 - tr_2 ;$$

et

$$H2_{n-1} = L1_{n-1} + \Delta fr_1, \text{ avec } \Delta fr_1 = tf_1 - tr_1.$$

A partir de ces relations, on peut exprimer les récurrences des différentes durées simplement en fonction des différences entre les temps de montée et de descente.

Par exemple, pour la durée L1n, on peut écrire :

$$L1_{n+1} = L1_n + \Delta fr1 - \Delta fr_2.$$

Puis, en exprimant la suite à partir du premier terme $L1_0$ (n=0):

$$L1_n = L1_0 - n*r, \text{ avec } r = \Delta fr_2 - \Delta fr_1.$$

On obtient donc une suite arithmétique dont la raison r est déterminable, lors de la conception du circuit, en fonction du nombre de cellules de base (éléments retardateurs) choisis et de leur écart entre temps de montée et temps de descente.

Une relation similaire peut s'écrire pour les durées H2, avec :

$$H2_n = H2_0 - n*r.$$

De façon similaire, en notant :

$H1_n$, la durée du niveau haut de rang n du signal de la sortie 131 (cette durée est liée au retard apporté par la première ligne 11 plus la deuxième porte 15) ;

$L2_n$, la durée du niveau bas de rang n du signal de la sortie 151 (cette durée est liée au retard apporté par la première ligne 11 plus la deuxième porte 15) ;

on peut obtenir les relations suivantes :

$$H1_n = H1_0 + n*r ;$$

et

$$L2_n = L2_0 + n*r.$$

Si la différence entre les temps de montée et les temps de descente (la raison r) est négative, les durées L1 et H2 augmentent tandis que les durées L2 et H1 diminuent. A l'inverse, si la raison r est positive, les durées L2 et H1 diminuent tandis que les durées L1 et H2 augmentent.

La figure 4 représente un mode de réalisation d'un générateur de nombres d'oscillations tirant profit de cette analyse.

En particulier, on souhaite pouvoir contrôler (afin de respecter des caractéristiques souhaitées pour le générateur aléatoire) le comportement temporel du générateur d'oscillations, c'est-à-dire la durée à partir de laquelle il s'arrête. Cette durée est non seulement fonction du retard apporté par les lignes à retard mais également des temps de montée et de descente de ces lignes.

Connaissant les comportements des cellules de base (éléments retardateurs) de la technologie dans laquelle on souhaite réaliser le générateur aléatoire, on peut déduire le nombre d'oscillations après lequel le générateur va s'arrêter. Avec une raison r positive, on peut fixer une limite quand la durée $L1_n$ devient nulle, c'est-à-dire pour $n = L1_0/r$. En pratique, les oscillations s'arrêtent quand la durée de l'impulsion devient inférieure au retard d'un élément retardateur.

Selon ce mode de réalisation, chaque branche est composée d'une ligne à retard 21, respectivement 27, dite symétrique c'est-à-dire ayant des temps de montée et de descente identiques ou très proches (écart entre le temps de montée et de descente inférieur au dixième de la raison r) en série avec un élément 22, respectivement 28, dit asymétrique, dont les temps de montée et de descente sont différents l'un de l'autre. Une borne 231 d'entrée de la première branche est reliée en sortie d'une première porte logique 23 de type NON-ET (NAND) dont une première entrée 235 reçoit un signal de déclenchement CTRL et dont une seconde entrée 233 reçoit la sortie de la deuxième branche. Une borne de sortie 253 de la première branche est reliée à une première entrée d'une deuxième porte 25 de type NON-ET dont une première entrée 255 reçoit le signal CTRL et dont la sortie 251 est reliée en entrée de la deuxième branche. La sortie du générateur d'un nombre aléatoire d'oscillations est par exemple la borne 253 ou la borne 233. Comme précédemment, cette sortie, donc le comptage des oscillations, peut correspondre en variante à la sortie 231 ou 251 de la porte 23, respectivement 25, ou plus généralement à n'importe quel point de la boucle. En pratique, la sortie est reliée en sortie d'un compteur asynchrone du nombre d'oscillations qui compte le nombre d'oscillations entre l'activation du générateur par le signal CTRL et l'arrêt des oscillations. Ce compteur (non représenté en figure 4) est, par exemple, constitué d'une bascule ou de plusieurs bascules en cascade, l'entrée d'horloge de la ou d'une première bascule recevant le signal de sortie du générateur. La ou les sorties des bascules fournissent un nombre sur un ou plusieurs bits (selon le nombre de bascules) dont généralement seuls les bits ou le bit de poids faible sont conservés pour constituer le nombre aléatoire.

Le cas échéant, plusieurs générateurs sont utilisés en parallèle pour augmenter le débit en bits aléatoires générés.

Pour réaliser les lignes à retard symétriques 21 et 27, on utilise, de préférence des inverseurs appariés, c'est-à-dire un nombre pair d'inverseurs dans chaque ligne. Par exemple, la ligne 21 comporte p paires d'inverseurs 3 en série tandis que la ligne 27 comporte q paires d'inverseurs 3 en série. Les nombres p et q peuvent être identiques ou différents l'un de l'autre.

En utilisant des paires d'inverseurs, non seulement le signal n'est pas inversé en sortie de chaque ligne, mais surtout chaque ligne présente un temps de montée et de descente identique ou très proche (écart inférieur au dixième de la raison divisée par p ou par q). En effet, en utilisant des cellules logiques identiques de la technologie concernée, même si un inverseur 3 réalisé dans cette technologie a un temps de montée différent de son temps de descente, une paire d'inverseurs 3 identiques forme un élément dont les temps de montée et de descente sont identiques. En notant tr et tf, les temps de montée et de descente d'un inverseur 3, le temps de montée et de descente d'une paire devient tr+tf (tr+tf ou tf+tr selon le sens du front d'entrée). Ainsi, même si les temps tf et tr sont différents l'un de l'autre, leur somme reste constante pour toutes les paires d'inverseurs. Les lignes 21 et 27 apportent donc un retard déterminable et constant quelle que soit la transition (montante ou descendante).

On peut utiliser n'importe quelle réalisation d'inverseur (par exemple des inverseurs CMOS formés de deux transistors en série, des portes NON-OU ou NON-ET à entrées interconnectées, etc.) pourvu que ces inverseurs respectent la condition d'associer, lorsqu'ils sont appariés en série, successivement temps de montée et temps de descente, ou inversement, afin que ces temps soient sommés quel que soit le front présent en entrée.

Pour réaliser les éléments asymétriques 22 et 24, on utilise un élément de type amplificateur logique (buffer) non inverseur, à l'exclusion de deux inverseurs identiques en série. Par exemple, on peut utiliser une porte de type OU, de type ET dont les deux entrées sont reliées, ou encore toute fonction logique que l'on peut ramener à une fonction inverseuse ne dépendant que d'une seule entrée et dont les temps de montée et de descente sont différents. Chaque élément 22 et 24 est choisi pour présenter un temps de montée différent de son temps de descente. De plus, les éléments 22 et 24 sont choisis pour présenter des écarts différents entre temps de montée et temps de descente. Ainsi, on introduit les écarts qui vont conditionner l'arrêt du générateur. En pratique, comme il ressort des formules établies plus haut, les portes 23 et 25 apportent également un décalage entre les temps de montée et de descente de chaque branche. Ce décalage doit être ajouté à celui introduit par l'élément 24, respectivement 22, pour obtenir les écarts, respectivement $\Delta fr_1$ et $\Delta fr_2$, donc les raisons des suites arithmétiques.

Un avantage de la réalisation proposée est que ces nombres p et q de paires d'inverseurs des lignes 21 et 27 n'influent pas sur la raison des suites arithmétiques définissant les oscillations. En effet, ils ne conditionnent que les premiers termes de chaque suite, c'est-à-dire les durées des premières impulsions qui suivent la commutation du signal CTRL pour activer la génération.

Selon un mode de réalisation simplifié, on prévoit un seul élément 22 ou 24, l'autre branche n'ayant que la ligne à retard symétrique.

Les lignes 21 et 27 peuvent être indifféremment placées en amont ou en aval des éléments 22 et 24 avec lesquels elles sont respectivement associées. En variante, les éléments 22 et 24 sont même intercalés à l'intérieur des lignes 21 et 27, entre des inverseurs ou des paires d'inverseurs qui les constituent.

Un avantage des modes de réalisation décrits est qu'il est désormais aisé de dimensionner un générateur d'oscillations et de pouvoir le caractériser. Ainsi, lors de la conception d'un circuit électronique comportant un générateur de nombres aléatoires, connaissant les écarts entre les temps de montée et de descente dans la technologie, il devient aisé de respecter un cahier des charges.

L'interprétation du nombre généré s'effectue en comptant les impulsions sur une des sorties 233 et 253 et en prenant, en tant que bit aléatoire, par exemple, le bit de poids faible à la fin de la période de comptage. La période de comptage est fixée par un signal d'horloge.

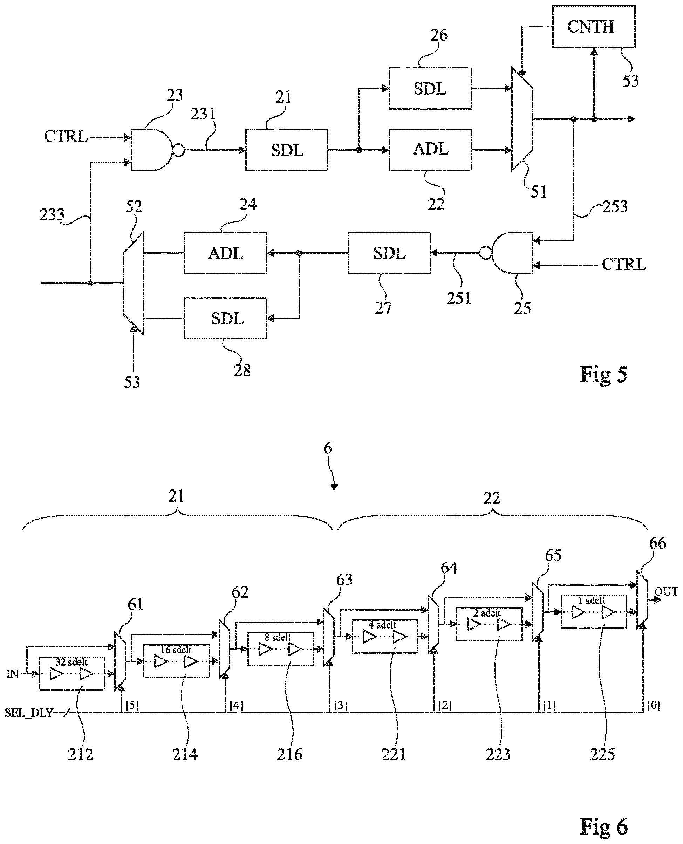

La figure 5 représente, de façon schématique, une variante de réalisation selon laquelle on cherche à minimiser la raison de la suite arithmétique, tout en la conservant aisément déterminable.

Selon cette variante, par rapport à la réalisation de la figure 4, on prévoit, en parallèle avec chaque élément 22, 24 ou ligne à retard asymétrique (ADL - Asymetric Delay Line), une deuxième ligne à retard symétrique (SDL - Symetric Delay Line) 26, respectivement 28. Les entrées des lignes à retard 22 et 26 sont reliées en sortie de la ligne 21. Les entrées des lignes 24 et 28 sont reliées en sortie de la ligne 27. Les sorties des lignes 22 et 26, respectivement 24 et 28, sont reliées à des entrées d'un multiplexeur deux vers un 51, respectivement 52, dont la sortie est reliée en entrée 253, respectivement 233, de la porte logique 25, respectivement 23. Le multiplexeur 51 est commandé par un signal issu d'un comptage (compteur 53, CNTH) des impulsions de son signal de sortie. En d'autres termes, le compteur détermine le nombre d'impulsions à partir duquel on commute de la ligne asymétrique 22 vers la ligne symétrique 26. Côté multiplexeur 52, on peut prévoir une commande par le même compteur 53 ou par un compteur différent qui compte alors les impulsions de la sortie du multiplexeur 52. En pratique, si on utilise un seul compteur, on le place sur la branche ayant le retard le plus long afin de ne pas commuter les multiplexeurs avant la fin des premières impulsions.

Une telle variante permet de rendre configurable la raison des suites arithmétiques et plus particulièrement de réduire cette raison afin de retarder l'arrêt du générateur.

En effet, en exécutant une boucle (une impulsion sur chaque branche) asymétrique et le reste des boucles uniquement avec les éléments symétriques (21, 26, 27 et 28), on minimise la raison de la suite. En reprenant les notations prises plus haut, la raison r se trouve divisée par le nombre de boucles. Cela permet, entre autres, d'augmenter le nombre d'impulsions circulant dans les lignes à retard du générateur tout en réduisant la taille de ces lignes à retard.

Le cas échéant, le compteur 53 est le compteur de comptage des impulsions dont le ou les bits de poids faibles sont utilisés, à l'arrêt des oscillations, pour définir le nombre aléatoire généré.

La figure 6 représente un mode de réalisation d'une ligne à retard 6, paramétrable à la fois en retard symétrique et en retard asymétrique.

La réalisation de la figure 6 peut constituer, à titre d'exemple particulier dans les réalisations précédentes, un mode de réalisation de la ligne à retard symétrique, par exemple 21, et de l'élément retardateur asymétrique, par exemple 22, d'une branche.

Selon ce mode de réalisation, on associe une ou plusieurs (dans l'exemple trois) lignes à retard symétriques 212, 214 et 216, c'est-à-dire ayant chacune des temps de montée et de descente identiques, à un ou plusieurs (dans l'exemple trois) éléments retardateur ou lignes à retard asymétriques 221, 223, 225, c'est-à-dire ayant chacun des temps de montée et de descente différents, chaque ligne asymétrique ou symétrique étant court-circuitable à l'aide d'un multiplexeur 61, 62, 63, 64, 65, 66 respectivement. En d'autres termes les entrées des lignes 212, 214, 216, 221, 223 et 225 sont respectivement reliées directement à une première entrée des multiplexeurs 61, 62, 63, 64, 65, 66 dont l'autre entrée est reliée à la sortie de la ligne à retard correspondante. Les sorties des multiplexeurs 61, 62, 63, 64 et 65 sont respectivement reliées aux entrées des lignes 214, 216, 221, 223, 225 et la sortie du multiplexeur 66 définit la sortie OUT de la ligne à retard paramétrable.

Chaque multiplexeur 61 à 66 est commandable individuellement, par exemple, par un bit différent, respectivement [5], [4], [3], [2], [1], [0] d'un mot SEL_DLY.

Dans une application à la réalisation d'un générateur de nombres d'oscillations du type illustré par la figure 4, la borne IN d'entrée de la ligne 6 est reliée en sortie (231 ou 251, figures 4 et 5) de la branche concernée.

Chaque ligne 212, 214, 216 est, de préférence, constituée d'une ou plusieurs paires d'inverseurs, c'est-à-dire d'éléments retardateurs ayant chacun des temps de montée et de descente identiques comme décrit plus haut. Dans l'exemple représenté, les lignes 212, 214 et 216 comportent respectivement 32, 16 et 8 paires d'inverseurs, soit 32, 16 et 8 éléments retardateurs symétriques unitaires (sdelt).

Les lignes asymétriques 221, 223, 225 apportent des retards identiques ou différents les unes des autres. De préférence, les lignes 221, 223 et 225 sont constituées d'éléments unitaires identiques, c'est-à-dire apportant le même décalage entre temps de montée et temps de descente. On prévoit alors des nombres différents de ces éléments unitaires dans chacune des lignes, ce qui rend le système paramétrable aisément avec une granularité optimale. Dans l'exemple représenté, les lignes 221, 223 et 225 comportent respectivement 4, 2 et 1 éléments retardateurs asymétriques unitaires (adelt).

Ainsi, la ligne à retard 6 est paramétrable à la fois en retard et en différence entre temps de montée et temps de descente. En prenant l'exemple d'éléments unitaires identiques dans les lignes 212, 214 et 216, et d'éléments unitaires identiques dans les lignes 221, 223 et 225, on peut choisir un retard symétrique compris entre 8 et 56 fois le retard de l'élément unitaire symétrique et un écart temporel entre front montant et front descendant compris entre 1 et 7 fois l'écart apporté par l'élément unitaire asymétrique.

Les éléments unitaires sont, par exemple, réalisés comme décrit plus haut en relation avec la figure 4.

Le nombre de lignes à retard symétriques et asymétriques dépend de la capacité de réglage souhaitée. Les éléments asymétriques ont non seulement des temps de montée et de descente différents mais aussi un délai intrinsèque qui contribue au délai total de la ligne à retard.

La réalisation de la figure 6 peut servir, par exemple, à intégrer une même architecture de générateur et à rendre cette structure paramétrable, que ce soit à la conception ou dans l'application.

La réalisation de la figure 6 peut être combinée à celle de la figure 5 en mettant en parallèle de chaque ligne asymétrique 221, 223, 225, une ligne symétrique de même retard, supprimant ainsi le court-circuit de la ligne attaquant les entrées supérieures (dans l'orientation de la figure 6) des multiplexeurs 64 à 66. En variante, on utilise des multiplexeurs 3 vers 1 dont deux entrées reçoivent les sorties respectives de deux lignes en parallèle de même retard, respectivement symétrique et asymétrique, et dont la troisième entrée reçoit directement la sortie du multiplexeur de rang précédent.

Dans la réalisation de la figure 6 ou de ses variantes, afin de faciliter le paramétrage, il serait souhaitable que les multiplexeurs 61 à 66 apportent des retards symétriques. Or, un multiplexeur usuel a un fonctionnement asymétrique en termes de temps de montée et de temps de descente.

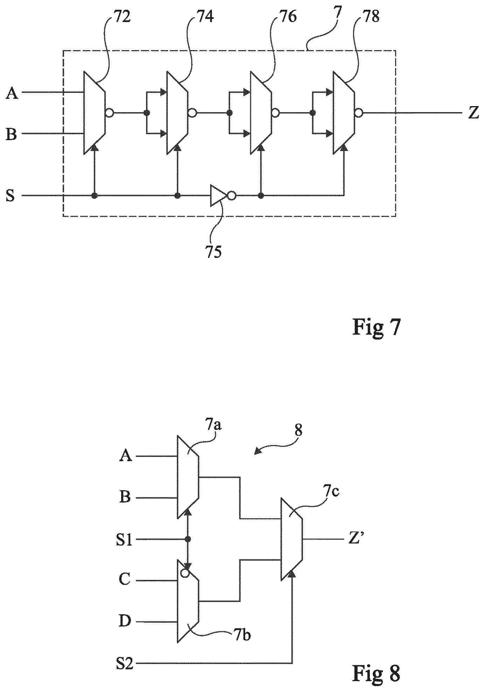

La figure 7 représente un mode de réalisation d'un multiplexeur 7 ayant un fonctionnement symétrique, c'est-à-dire un temps de montée et un temps de descente identiques.

Le multiplexeur 7 de la figure 7 est un multiplexeur deux vers un, c'est-à-dire qu'il sélectionne l'une de ses deux entrées A ou B et fournit le signal correspondant en sortie Z. La sélection entre l'entrée A ou B s'effectue par un signal de commande S.

Le multiplexeur 7 comporte quatre éléments de multiplexage ou de sélection deux vers un. On peut considérer que le multiplexeur 7 est constitué de 4 multiplexeurs unitaires 72, 74, 76 et 78 associés en chaîne. Les multiplexeurs sont des multiplexeurs inverseurs. Un premier multiplexeur 72 a ses bornes d'entrée respectivement reliées aux entrées A et B. Un deuxième multiplexeur 74 a ses deux entrées reliées ensemble à la sortie du premier multiplexeur 72. Un troisième multiplexeur 76 a ses deux entrées reliées ensemble à la sortie du deuxième multiplexeur 74. Un quatrième multiplexeur 78 a ses deux entrées reliées ensemble à la sortie du troisième multiplexeur 76 et sa sortie fournit la sortie Z. Le signal S commande directement les multiplexeurs 72 et 74 et, après traversée d'un inverseur 75, les multiplexeurs 76 et 78.

Le fait que les multiplexeurs 74, 76 et 78 aient leurs entrées interconnectées engendre qu'ils n'effectuent en fait aucune sélection. Toutefois, en supposant que tous les multiplexeurs 72, 74, 76 et 78 sont identiques, ils ont tous des temps de montée et de descente identiques. De plus, ils ont tous un comportement similaire lors d'un front sur leur première entrée et tous un comportement similaire lors d'un front sur leur deuxième entrée.

En notant tr les temps de montée, tf les temps de descente et en affectant ces notations d'un premier indice A, respectivement B, selon que le front est sur l'entrée A (la première entrée du multiplexeur unitaire concerné) ou B (la deuxième entrée du multiplexeur unitaire concerné) et d'un deuxième indice 72, 74, 76 ou 78 selon le multiplexeur unitaire concerné, on peut écrire :

$$tr_{A72} = tr_{A74} = tr_{A76} = tr_{A78} = tr_A \; ;$$

$$tf_{A72} = tf_{A74} = tf_{A76} = tf_{A78} = tf_A \; ;$$

$$tr_{B72} = tr_{B74} = tr_{B76} = tr_{B78} = tr_B \; ;$$

et

$$tf_{B72} = tf_{B74} = tf_{B76} = tf_{B78} = tf_B.$$

En raison de l'inversion de la commande des deux multiplexeurs 76 et 78 par rapport à celle des multiplexeurs 72 et 74, les temps de montée et de descente du multiplexeur 7, de l'entrée A ou B jusqu'à la sortie Z, peuvent s'écrire, selon qu'un front montant r ou descendant f est présent sur l'entrée A ou sur l'entrée B :

$$tr_{AZ} = tf_{A72} + tr_{A74} + tf_{B76} + tr_{B78} \; ;$$

$$tf_{AZ} = tr_{A}72 + tf_{A}74 + tr_{B}76 + tf_{B}78 \; ;$$

$$tr_{BZ} = tf_{B}72 + tr_{B}74 + tf_{A}76 + tr_{A}78 \; ;$$

et

$$tf_{BZ} = tr_{B}72 + tf_{B}74 + tr_{A}76 + tf_{A}78.$$

Comme les temps de montée et de descente unitaire sont identiques pour une entrée donnée, on en déduit :

$$tr_{AZ} = tf_{AZ} = tr_{BZ} = tf_{BZ} = tr_{A} + tf_{A} + tr_{B} + tf_{B}.$$

Par conséquent, les temps de montée et de descente du multiplexeur 7 sont identiques quelle que soit l'entrée considérée. Le multiplexeur est donc symétrique avec la définition donnée plus haut.

En variante, on peut prévoir d'inverser la commande à d'autres endroits pourvu que deux multiplexeurs sélectionnent leurs premières entrées respectives quand les deux autres sélectionnent leurs deuxièmes entrées respectives. Dans ce cas, on veillera cependant à ce que le retard de propagation apporté par les inverseurs ne soit pas supérieur au temps de propagation minimum d'un multiplexeur unitaire, faute de quoi la sortie est faussée. Un avantage du mode de réalisation de la figure 7 est qu'il garantit que la sélection des multiplexeurs 76 et 78 soit active avant que le signal (le front) ait fini de traverser les multiplexeurs 72 et 74.

Bien que cela n'apporte pas d'avantage en termes de symétrie, on peut prévoir d'utiliser 8, 12, 16 et plus généralement tout multiple de quatre de multiplexeurs unitaires pourvu que la moitié soit commandée en inverse par rapport à l'autre moitié. Cela permet, par exemple, d'augmenter le temps de propagation sans nuire à la symétrie du fonctionnement.

Un avantage du mode de réalisation de la figure 7 est qu'il est indépendant de la structure interne des multiplexeurs unitaires. En effet, pourvu que l'on utilise des multiplexeurs unitaires identiques, le fonctionnement décrit est respecté.

Un multiplexeur tel que représenté en figure 7 a de multiples applications. En particulier, il est fréquent qu'il soit avantageux d'avoir un fonctionnement symétrique.

A titre d'exemple particulier d'application, le multiplexeur de la figure 7 peut être utilisé pour réaliser chacun des multiplexeurs 61, 62, 63, 64, 65 et 66 de la réalisation de la figure 6. Un avantage est alors que la raison des suites d'impulsions du générateur de nombres reste uniquement liée aux éléments asymétriques 221, 223 et 225, ce qui facilite le dimensionnement.

La structure du multiplexeur 7 de la figure 7 peut être déclinée pour réaliser des multiplexeurs à plus de deux entrées.

La figure 8 représente un mode de réalisation d'un multiplexeur symétrique 8 quatre vers un.

Selon ce mode de réalisation, on utilise trois multiplexeurs deux vers un du type de celui de la figure 7. Un premier multiplexeur 7a définit deux entrées A et B. Un deuxième multiplexeur 7b définit des entrées C et D. Les sorties respectives des multiplexeurs 7a et 7b sont connectées aux deux entrées d'un troisième multiplexeur 7c dont la sortie définit la sortie Z' du multiplexeur quatre vers un. Les multiplexeurs 7a et 7b sont respectivement commandés par un signal S1 et par son inverse. Le multiplexeur 7c est commandé par un signal S2. Par exemple, en supposant un mot de sélection sur deux bits, le signal S2 est constitué par le bit de poids fort et le signal S1 par le bit de poids faible.

Dans un générateur de nombres aléatoires du type décrit ci-dessus, l'interprétation de la sortie du générateur requiert de compter les impulsions présentes en sortie. C'est ce comptage qui détermine le nombre tiré. Par exemple, on prend, comme bit aléatoire généré par le générateur 20, le bit de poids faible du compte des impulsions présentes en sortie du générateur entre son déclenchement et un signal de lecture du compteur, postérieur à l'arrêt des oscillations. L'intervalle de temps entre le déclenchement du générateur et le signal de lecture est choisi en fonction de la plage d'intervalles de temps possible conditionné par le dimensionnement des lignes à retard du générateur.

Toutefois, dans un compteur, il peut exister un déséquilibre entre les comptes d'états 1 et d'états 0 en particulier si un des états du signal à compter devient trop court par rapport à l'autre. Ce phénomène est dû au fait qu'à partir d'une certaine durée d'impulsion (dans le sens décroissant de durée), le compteur n'est capable de prendre en compte l'impulsion que dans un sens selon la parité du compte courant qu'il contient. On se retrouve alors avec un déséquilibre entre la probabilité de tirer un 1 et de tirer un 0. En d'autres termes, avec un générateur du type de celui de la figure 4 (mais également avec celui de la figure 2), lorsque le rapport cyclique devient trop déformé, l'utilisation de la sortie du générateur comme horloge de comptage conduit à ce que la durée de l'impulsion (basse ou haute selon la sortie concernée) est inférieure au temps minimum de prise en compte de la bascule. Or ce temps diffère pour un état haut et pour un état bas. Par conséquent, quelle que soit la sortie utilisée, la bascule sortira de son fonctionnement normal et on ne peut pas déterminer à l'avance, lors de la conception, quelle sortie sera concernée.

Ce problème est susceptible de se rencontrer non seulement pour compter le nombre d'oscillations dans un générateur tel que décrit dans la présente description mais plus généralement pour compter des évènements de faible durée dans un signal, par exemple un détecteur de perturbations transitoires (glitch).

En effet, un compteur, qu'il soit asynchrone ou non fonctionne normalement avec une horloge, dite carrée, c'est-à-dire de rapport cyclique proche de 50 %. Or, dans le cas du générateur décrit ci-dessus, le rapport cyclique de l'horloge du compteur asynchrone, qui correspond à la sortie 231 ou 251 (ou 233, 253), diminue à chaque période jusqu'à l'arrêt de l'oscillation, ou au contraire augmente à chaque période jusqu'à l'arrêt de l'oscillation. Par conséquent, une des sorties s'arrête à l'état 0 et l'autre s'arrête à l'état 1. Toutefois, on ne peut généralement pas savoir avec certitude à l'avance laquelle des sorties s'arrêtera dans l'état 1 et laquelle s'arrêtera dans l'état 0.

Côté compteur, on utilise des bascules qui requièrent dans leurs spécifications, une durée minimum de l'horloge à l'état haut (1) et une durée minimum du signal d'horloge à l'état bas (0), par exemple arbitrairement 110 ps pour la durée minimum à l'état haut et 87 ps pour la durée minimum à l'état bas. Par conséquent, quand la bascule d'entrée du compteur reçoit une horloge de rapport cyclique très faible ou très grand, il peut finir par fonctionner hors spécification et l'impulsion du signal d'horloge n'est alors pas prise en compte.

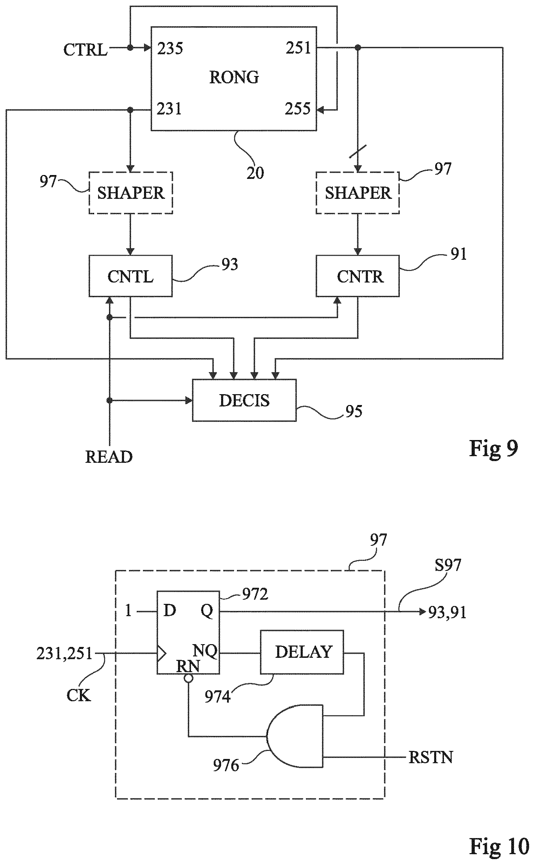

La figure 9 représente un mode de réalisation d'un générateur de nombres aléatoires du type décrit ci-dessus avec ses éléments de comptage des impulsions permettant de mettre en forme le nombre généré.

La figure 9 illustre une variante dans laquelle les nombres d'impulsions générés sont prélevés en sortie des portes 231 et 251.

Selon ce mode de réalisation, chaque sortie 251, 231 du générateur de nombre d'oscillations aléatoire 20 (RONG), par exemple tel que décrit en figure 4, est reliée en entrée d'un compteur, respectivement 91 (CNTR), 93 (CNTL). Chaque compteur 91, 93 compte les impulsions du signal de sortie correspondant du générateur. Chaque compteur est un compteur asynchrone, par exemple de type bascule D.

La lecture des compteurs 91 et 93 est déclenchée par un signal READ qui transfère les comptes vers un circuit 95 de décision (DECIS) ou de combinaison. Le circuit 95 reçoit également les signaux de sortie 231 et 251 afin de connaître, lors de la décision, les états de ces signaux à l'arrêt des oscillations.

Fonctionnellement, on utilise des compteurs du nombre d'oscillations, l'un avec une sortie du générateur 20, l'autre avec l'autre sortie du générateur 20. Comme indiqué ci-dessus, l'un des compteurs s'arrêtera de fonctionner avant l'autre, c'est-à-dire que sa bascule d'entrée arrêtera de fonctionner avant la bascule d'entrée de l'autre, sous l'effet du fait que les durées minimales de fonctionnement des bascules sont différentes pour l'état bas et pour l'état haut. En fait, un des compteurs s'arrêtera sous l'effet d'une oscillation ne respectant pas son temps minimum à l'état bas tandis que l'autre compteur s'arrêtera sous l'effet d'une oscillation ne respectant pas son temps minimum à l'état haut.

Selon les applications, le critère de choix, par le circuit 95 entre les sorties des compteurs 91 et 93 selon les états fournis par les sorties 231 et 251, diffère. Ce critère de choix peut être conditionné par une simulation du fonctionnement du générateur afin de déterminer si les bascules s'arrêtent à cause du temps minimum à l'état haut ou à cause du temps minimum à l'état bas.

Par exemple, si l'on attache de l'importance à la parité du résultat de comptage et en supposant que la bascule du compteur qui s'arrête le premier s'arrête sous l'effet d'une durée à l'état bas (état 0) trop faible, la valeur du compteur correspondant sera plus faible que la valeur de l'autre compteur. Si cet effet se cumule avec un fonctionnement asymétrique de la bascule, c'est-à-dire un basculement plus facile de 0 vers 1 que de 1 vers 0 (ou inversement), cela introduit un biais dans la génération du nombre aléatoire qui n'est pas souhaitable. On sélectionne alors celui des compteurs qui s'est arrêté sur une commutation de 1 vers 0.

Selon encore un autre exemple où la parité a moins d'importance qu'un nombre élevé d'oscillations, on sélectionne le compteur qui s'arrête en dernier.

Selon encore un autre exemple, la décision dépend de la relation entre les compteurs. Ainsi, on conserve la valeur :

du compteur ayant le plus grand compte si les deux comptes ont la même parité ; ou
du compteur ayant le plus grand compte si ce compte est pair et le plus petit si le compte est impair.

Selon encore un autre exemple, on considère que celui des compteurs qui continue de fonctionner présente un fort risque de fonctionner de façon dissymétrique car l'autre compteur s'est déjà arrêté. Dans ce cas, le bloc 95 sélectionne le résultat du compteur qui s'arrête le premier, c'est-à-dire le premier qui, lors d'un changement d'état de la sortie 231 ou 251, ne change pas son bit de poids faible. Cet exemple de réalisation est préféré dans le cas où l'on n'a pas déterminé, en simulation, la cause d'arrêt des bascules (temps minimum à l'état bas ou temps minimum à l'état haut).

Le fait de compter les deux sorties et de prendre l'une ou l'autre selon le cas permet de ne rater aucune impulsion.

On notera que le circuit de comptage décrit en relation avec la figure 9 s'applique plus généralement à tout générateur de nombres aléatoires et pas nécessairement à celui de la figure 4. En particulier, il peut être mis en oeuvre pour tout générateur de nombres aléatoires ayant des lignes à retard rebouclées l'une sur l'autre (par exemple, figure 2).

Selon un autre mode de réalisation de cet aspect de comptage, les signaux fournis par les sorties 253 et 233 sont mis en forme avant d'être comptés afin d'éliminer certains ratés possibles dans le comptage. Pour cela, des circuits de mise en forme optionnels (SHAPER) 97 sont intercalés entre les sorties respectives 251 et 231 et les compteurs 91 et 93.

La figure 10 représente un mode de réalisation d'un circuit de mise en forme 97 d'un signal impulsionnel.

Le circuit 97 comporte une bascule 972 de type D dont l'entrée D est forcée à l'état haut (1) et dont la sortie non inversée Q définit la sortie S97 fournissant le signal mis en forme. L'entrée d'horloge CK de la bascule 972 définit l'entrée du circuit recevant le signal impulsionnel à mettre en forme. La sortie inversée NQ de la bascule 972 est reliée, par l'intermédiaire d'un élément retardateur non inverseur 974 (DELAY) à une première entrée d'une porte logique 976 de type ET dont une sortie est reliée à l'entrée de réinitialisation RN (active sur front montant) de la bascule 972. Une deuxième entrée de la porte 976 est destinée à recevoir un signal RSTN d'activation du circuit 97. Quand le signal RSTN est à l'état 0, le circuit 97 n'est pas actif et la sortie S97 est en permanence à l'état 0. La porte 976 est donc optionnelle si l'on n'a pas besoin de désactiver le circuit 97.

La valeur du retard introduit par l'élément 974 est choisie pour être supérieure à la largeur minimale d'impulsion que peut capturer la bascule D.

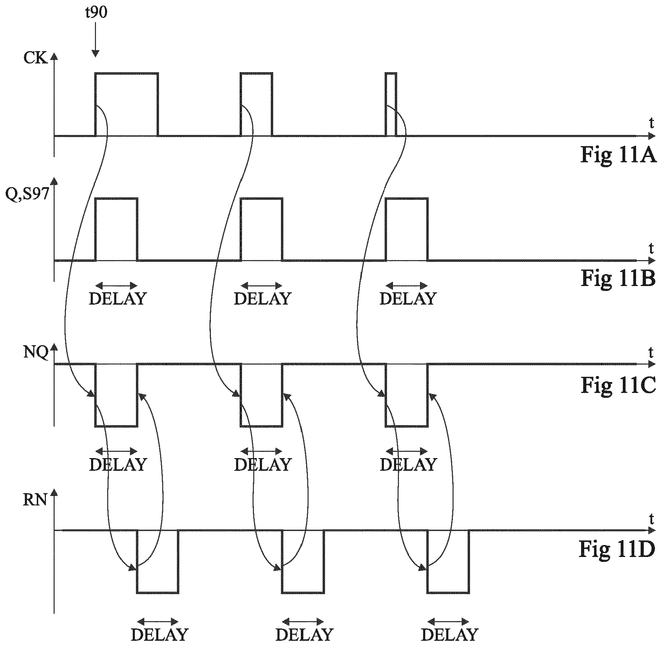

Les figures 11A, 11B, 11C et 11D illustrent, sous forme de chronogrammes, le fonctionnement du circuit de mise en forme de la figure 10. La figure 11A représente un exemple d'allure du signal d'entrée CK à mettre en forme. La figure 11B représente un exemple d'allure correspondante du signal de la sortie Q (S97). La figure 11C représente un exemple d'allure correspondante de la sortie NQ. La figure 11D représente un exemple d'allure correspondante du signal de l'entrée RN.

On suppose un signal impulsionnel CK d'impulsions positives.

Initialement, la sortie Q (donc la sortie S97) est à l'état 0, la sortie NQ est à l'état 1. L'entrée RN est à l'état 1. On suppose le signal RSTN actif (état 1).

A l'apparition (instant t90) d'un front montant sur le signal d'horloge CK, comme l'entrée D est à l'état 1 et que l'entrée RN est à l'état 1, cette impulsion est transmise sur la sortie Q qui bascule à l'état 1. Par contre, la sortie NQ (inverse de la sortie Q) bascule à l'état 0. Cet état est transmis, avec un retard DELAY sur l'entrée RN (en considérant le retard apporté par la porte 976 inclus dans la valeur DELAY). La commutation de l'entrée RN à la fin de retard DELAY provoque le forçage de la sortie Q à l'état 0 et, par conséquent, de la sortie NQ à l'état 1, ce qui provoque, à son tour, toujours à l'issue du retard DELAY, le basculement de l'entrée RN à l'état 0. La bascule est alors prête à prendre un nouvel état en compte. La partie droite des chronogrammes illustre le fonctionnement avec une impulsion CK de durée inférieure au retard DELAY. Le retard DELAY fixe la durée des impulsions du signal de sortie indépendamment de la durée de l'impulsion du signal CK. Par conséquent, même si l'impulsion du signal CK est théoriquement trop courte pour que sa descente soit prise en compte, elle est quand même présente sur la sortie Q.

La durée DELAY fixe la durée des impulsions du signal S97, donc d'entrée des compteurs dans la réalisation de la figure 10.

Pour réaliser un circuit de mise en forme fonctionnant avec un signal impulsionnel d'impulsions négatives, la sortie de la porte 976 est reliée à l'entrée de mise à un de la bascule, l'entrée est forcée à l'état 0 et l'élément retardateur reçoit la sortie non inversée Q tandis que la sortie du circuit de mise en forme est définie par la sortie inversée NQ. Le fonctionnement se transpose sans difficulté des explications données ci-dessus.

Un avantage des modes de réalisation qui ont été décrits est qu'ils permettent de concevoir ou de configurer un générateur de nombres aléatoires de façon fiable et déterminable. Ainsi, on peut respecter les critères fixés par un cahier des charges et valider que le générateur respecte ce cahier des charges.

Un autre avantage est que la solution décrite est compatible avec l'utilisation de cellules standards d'une technologie donnée.

Un autre avantage est que l'ensemble du générateur est réalisable avec des éléments logiques.

Pour un générateur de nombres aléatoires, le nombre est prélevé soit après un intervalle de temps fixe, déclenché par l'activation du générateur (signal CTRL) et choisi pour être supérieur au temps maximum d'arrêt du générateur), soit en détectant l'arrêt du ou des compteurs.

Pour réaliser un générateur de nombres non clonables de type identifiant d'un circuit intégré, les lignes à retard et la raison des suites arithmétiques sont dimensionnées afin de fixer le nombre d'oscillations. Le prélèvement du nombre est effectué après l'arrêt du générateur comme pour un générateur de nombres aléatoires et on ne conserve de préférence qu'une partie des bits (les plus significatifs).

Divers modes de réalisation ont été décrits. Diverses variantes et modifications apparaîtront à l'homme de l'art.

En particulier, le choix des retards apportés par les lignes à retard symétriques et des décalages apportés par les éléments retardateurs asymétriques dépend de l'application et du cahier des charges du générateur. Enfin, la mise en oeuvre pratique des modes de réalisation qui ont été décrits est à la portée de l'homme du métier à partir des indications fonctionnelles données ci-dessus.

**Revendications**

1. Circuit (20) de génération d'un nombre d'oscillations comportant :

   une première branche comprenant au moins une ligne à retard (21) apportant des retards symétriques sur fronts montants et sur fronts descendants, et au moins un élément retardateur asymétrique (22) constitué d'un circuit logique apportant une fonction logique que l'on peut ramener à une fonction non inverseuse ne dépendant que d'une seule entrée et dont les temps de montée et de descente sont différents, l'élément retardateur asymétrique apportant des retards différents sur fronts montants et sur fronts descendants ;
   une deuxième branche, rebouclée sur la première et comprenant au moins une ligne à retard (27) apportant des retards symétriques sur fronts montants et sur fronts descendants,
   dans lequel des portes (25, 23) de type NON-ET, combinant les sorties respectives des branches avec un signal (CTRL) de commande, sont intercalées entre les sorties respectives (253, 233) de chaque branche et l'entrée (251, 231) de l'autre branche.

2. Circuit selon la revendication 1, dans lequel la deuxième branche comporte en outre au moins un élément retardateur asymétrique (24) apportant des retards différents sur fronts montants et sur fronts descendants.

3. Circuit selon l'une quelconque des revendications 1 ou 2, dans lequel les lignes à retard (21, 27) sont constituées d'éléments logiques ramenant à une fonction non inverseuse à une seule entrée et dont les temps de montée et de descente sont identiques.

4. Circuit selon l'une quelconque des revendications 1 à 3, dans lequel la ou les branches comportent en outre, une deuxième ligne à retard (26, 28) apportant des retards symétriques sur fronts montants et sur fronts descendants, connectée en parallèle sur l'élément retardateur (22, 24) de la branche concernée.

5. Générateur de nombres comportant :

   au moins un circuit (20) selon l'une quelconque des revendications 1 à 4 ; et
   au moins un compteur (91, 93) du nombre d'oscillations générées par ledit circuit.

6. Dispositif électronique comportant au moins un générateur selon la revendication 5, ledit circuit (20) étant configuré pour générer un nombre aléatoire d'oscillations.

7. Dispositif électronique comportant au moins un générateur selon la revendication 5, ledit circuit (20) étant configuré pour générer un nombre reproductible.

**Patentansprüche**

1. Eine Schaltung (20) zur Erzeugung einer Anzahl von Schwingungen, umfassend:

   einen ersten Zweig mit mindestens einer Verzögerungsleitung (21), die symmetrische Verzögerungen bei steigenden Flanken und bei fallenden Flanken einführt, und mindestens einem asymmetrischen Verzögerungselement (22), das aus Logikelementen gebildet ist, die einer nichtinvertierenden Funktion mit einem einzigen Eingang entsprechen und unterschiedliche Anstiegs- und Abfallzeiten aufweisen, wobei das asymmetrische Verzögerungselement unterschiedliche Verzögerungen bei steigenden Flanken und bei fallenden Flanken einführt;
   einen zweiten Zweig, der auf den ersten Zweig zurückgeschleift ist und mindestens eine Verzögerungsleitung (27) aufweist, die symmetrische Verzögerungen bei steigenden Flanken und bei fallenden Flanken einführt, wobei Gatter (25, 23) vom NICHT-ODER- bzw. NAND-Typ, die die jeweiligen Ausgänge der Zweige mit einem Steuersignal (CTRL) kombinieren, zwischen den jeweiligen Ausgängen (253, 233) jedes Zweiges und dem Eingang (251, 231) des anderen Zweiges eingefügt sind.

2. Schaltung nach Anspruch 1, wobei der zweite Zweig ferner mindestens ein asymmetrisches Verzögerungselement (24) aufweist, das bei steigenden Flanken und bei fallenden Flanken unterschiedliche Verzögerungen einführt.

3. Schaltung nach Anspruch 1 oder 2, bei der die Verzögerungsleitungen (21, 27) aus logischen Elementen gebildet sind, die einer nichtinvertierenden Funktion mit einem Eingang entsprechen und identische Anstiegs- und Abfallzeiten haben.

4. Schaltung nach einem der Ansprüche 1 bis 3, wobei der Zweig oder die Zweige ferner eine zweite Verzögerungsleitung (26, 28) aufweist bzw. aufweisen, die symmetrische Verzögerungen bei steigenden Flanken und bei fallenden Flanken einführt und die zu dem Verzögerungselement (22, 24) des betreffenden Zweiges parallel geschaltet ist.

5. Ein Zahlengenerator, umfassend:

mindestens eine Schaltung (20) nach einem der Ansprüche 1 bis 4; und
mindestens einen Zähler (91, 93) der Anzahl der von dieser Schaltung erzeugten Schwingungen.

6. Elektronische Vorrichtung mit mindestens einem Generator nach Anspruch 5, wobei die Schaltung (20) so konfiguriert ist, dass sie eine Zufallszahl von Schwingungen erzeugt.

7. Elektronische Vorrichtung mit mindestens einem Generator nach Anspruch 5, wobei die Schaltung (20) so konfiguriert ist, dass sie eine reproduzierbare Zahl erzeugt.

**Claims**

1. A circuit (20) for generating a number of oscillations comprising:

a first branch comprising at least one delay line (21) introducing symmetrical delays on rising edges and on falling edges and at least one asymmetrical delay element (22) formed of logic elements equivalent to a single-input non-inverting function having different rise and fall times, the asymmetrical delay element introducing different delays on rising edges and on falling edges;
a second branch, looped back on the first one and comprising at least one delay line (27) introducing symmetrical delays on rising edges and on falling edges,
wherein NAND-type gates (25, 23) combining the respective outputs of the branches with a control signal (CTRL) are interposed between the respective outputs (253, 233) of each branch and the input (251, 231) of the other branch.

2. The circuit of claim 1, wherein the second branch further comprises at least one asymmetrical delay element (24) introducing different delays on rising edges and on falling edges.

3. The circuit of claim 1 or 2, wherein the delay lines (21, 27) are formed of logic elements equivalent to a single-input non-inverting function having identical rise and fall times.

4. The circuit of any of claims 1 to 3, wherein the branch(es) further comprise a second delay line (26, 28) introducing symmetrical delays on rising edges and on falling edges, connected in parallel on the delay element (22, 24) of the concerned branch.

5. A number generator comprising:

at least one circuit (20) of any of claims 1 to 4; and
at least one counter (91, 93) of the number of oscillations generated by said circuit.

6. An electronic device comprising at least one generator of claim 5, said circuit (20) being configured to generate a random number of oscillations.

7. An electronic device comprising at least one generator of claim 5, said circuit (20) being configured to generate a

reproducible number.

**Fig 1**

**Fig 2**

Fig 3A

Fig 3B

Fig 3C

Fig 3D

Fig 3E

Fig 4

Fig 5

Fig 6

Fig 7

Fig 8

Fig 9

Fig 10

t90

CK

Fig 11A

Q,S97

DELAY          DELAY          DELAY

Fig 11B

NQ

Fig 11C

DELAY          DELAY          DELAY

RN

Fig 11D

DELAY          DELAY          DELAY

**EP 3 242 398 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20110163818 A
- FR 3023396 A
- US 20120221616 A